# EUROPEAN PATENT SPECIFICATION

(11) **EP 0 589 241 B1**
(45) Date of publication and mention of the grant of the patent: **28.04.1999**
(21) Application number: 93113813.5
(22) Date of filing: 30.08.1993
(51) Int. Cl.: G03F 7/004

(54) **Photosensitive dielectric sheet composition and multilayer interconnect circuits**
Photoempfindliches dielektrisches Schichtmaterial und untereinander verbundene Mehrschichtschaltungen
Composition photosensible pour feuille diélectrique et circuits multicouches interconnectés

(30) Priority: 23.09.1992 US 946862
(43) Date of publication of application: 30.03.1994
(73) Proprietor: E.I. DU PONT DE NEMOURS AND COMPANY, Wilmington Delaware 19898 (US)
(72) Inventor: Suess, Terry R., Releigh, North Carolina 27614 (US); Nebe, William John, Wilmington, Delaware 19808 (US)
(74) Representative: von Kreisler, Alek, Dipl.-Chem.

(56) References cited:
- EP-A- 0 186 163
- EP-A- 0 347 615
- EP-A- 0 347 616
- EP-A- 0 357 063
- EP-A- 0 432 907
- US-A- 4 737 446
- US-A- 5 100 764

## Description

### FIELD OF THE INVENTION

The invention relates to the manufacture of multilayer interconnect circuits. More particularly, the invention relates to making multilayer interconnect circuits using photosensitive dielectric sheets.

### BACKGROUND OF THE INVENTION

Complex electronic circuits generally require that the circuit be constructed of several layers of conductors separated by insulating dielectric layers. The conductive layers are interconnected between levels by electrically conductive pathways through the dielectric called vias. Such a multilayer interconnect structure allows a circuit to be more compact.

One well known method for constructing a multilayer interconnect circuit is by sequentially printing and firing thick film conductors and insulating dielectrics through a patterned screen mesh onto a rigid insulative substrate. The rigid substrate provides mechanical support, dimensional stability, and facilitates registration of the patterned thick film conductor and dielectric layers. However, the thick film process is disadvantageous in that printing through a screen mesh can result in pinholes or voids in the dielectric layer which can cause shorting between conductor layers. If the thick film dielectric is formulated to allow sufficient flow of the paste during the printing operation and thus to minimize the tendency to form pinholes, then the maintenance of small vias is likely to be compromised by the flow of dielectric paste into the via hole. Also, the repetitive printing and firing steps for each layer are time consuming and expensive.

Another method for constructing multilayer inter connect circuits employs thick film conductors and green dielectric sheets comprising inorganic dielectric powders dispersed in an organic polymer binder. Vias are formed in the individual sheets by mechanical punching or laser drilling. The dielectric sheets containing vias are laminated in registry to a dimensionally stable insulative substrate on which a conductor pattern has been formed and the dielectric is fired. Next the vias are metallized and a second conductor layer is formed on the exposed surface of the dielectric layer in registry with the vias. The sequential steps of adding dielectric tape layers and metallizations are repeated until the desired circuit is obtained. Processes utilizing green dielectric sheets sequentially laminated to dimensionally stable substrates are further described in US 4,655,864 and US 4,645,552. Using dielectric in sheet form avoids the printing and flow drawbacks of the thick film paste dielectric. But, via formation by mechanical and laser means is time consuming. Also, registration of the via arrays in the different sheets is difficult and the mechanical punch stresses and deforms the sheet surrounding the via.

In U.S. Patent 5,032,216, Felten discloses via formation by diffusion patterning. A chemical which renders the green dielectric water soluble is applied to the sheet in the via array pattern. During drying, the chemical diffuses into the green dielectric material. The dielectric is then developed in water to form the desired via pattern. This method forms via matrices in significantly less time than the mechanical punching and laser drilling methods. However, the diffusion chemical must be screen printed onto the green sheet and then dried above room temperature. Consequently, registration of the pattern on different sheets is difficult, and the minimum size of the vias is limited to approximately 0.15-0.20 mm (6-8 mils) by the screen mesh resolution and the ability of the chemical to difuse into the green dielectric. Plugging of the screen mesh is also problematic.

In U.S. patent 4,613,560 Dueber discloses a photosensitive ceramic coating composition. It is developable by a non-aqueous organic liquid such as 1,1,1-trichloroethane. The composition can be formulated into a thick film paste, or cast as a film which is then laminated to a rigid substrate, exposed, developed and fired to form a dielectric layer in a multilayer circuit. This method avoids the disadvantages of screen printing. But, the non-aqueous organic developer requires special handling and disposal, and the need to laminate the cast film to a rigid support for processing limits use of the composition.

In U.S. Patent 4,912,019 Nebe discloses another photosensitive ceramic coating composition useable as a thick film paste or a supported film. Unlike the Deuber compositions, those of Nebe are developable in an aqueous solution containing only 1 wt.% sodium carbonate. Ordinary disposal systems can accept this developer without any special handling. However, as with the Dueber films, the films of Nebe are laminated to a rigid support, exposed, developed and then fired in order to form a dielectric layer in a multilayer circuit. The need for a rigid support disadvantageously limits the uses of the film.

Despite the foregoing advances in dielectric compositions, a continuing need exists for a dielectric composition which is self-supporting in the green stage, and can be quickly patterned with a via and/or circuit array. A need also exists for a dielectric film which can be processed in a variety of ways adding flexibility to the manufacture of the multilayer interconnect circuit.

### SUMMARY OF THE INVENTION

The invention is directed to a photosensitive dielectric sheet composition and the manufacture of multilayer interconnect circuits using said sheet. The sheet is self-supporting and developable in a dilute aqueous solution. Multilayer interconnect circuits can be produced with sheets exposed from one or both sides, or to a controlled depth.

### DETAILED DESCRIPTION OF THE INVENTION

The castable photosensitive self-supporting dielectric sheet composition of the invention comprises an admixture of:
(a) finely divided particles of an inorganic binder, and
(b) optionally, finely divided particles of ceramic solids; dispersed in an organic medium containing:
(c) an organic polymeric binder comprising an amine-containing organic polymer or a copolymer, an interpolymer or mixtures thereof, each copolymer or interpolymer comprising (1) a nonacidic comonomer of C₁-C₁₀ alkyl acrylate, C₁-C₁₀ alkyl methacrylate, styrene, substituted styrene or combination thereof and (2) an acidic comonomer comprising an ethylenically unsaturated carboxylic acid containing moiety, the copolymer, interpolymer or mixture having an acid content of at least 15% by weight of the total polymer weight, and the weight average molecular weight of the binder being in the range of 50,000-500,000 or greater and the average glass transition temperature of the binder being in the range of 50°-100°C, and
(d) a photoinitiator dissolved in
(e) photohardenable monomer, and
(f) an organic solvent;
the composition upon imagewise exposure to actinic radiation being developable in a dilute aqueous acidic or caustic solution containing 0.8-2.0% by weight acid or base. The invention also relates to a photosensitive self-supporting dielectric sheet as set out in claim 7 and to methods for making a multilayer interconnect using said dielectric sheet as set out in claims 13 and 15.

### INORGANIC BINDER

The inorganic binder is selected to be chemically inert with respect to the other materials in the system, possesses the desired electrically insulative characteristics and has the appropriate physical properties relative to any ceramic solids in the body.

The basic physical properties that are preferred for the inorganic binder are (1) that it have a sintering temperature below that of any ceramic solids in the body, and (2) that it undergo viscous phase sintering at the firing temperatures used.

When, as is usual, the inorganic binder component of the ceramic unfired tape is a glass, it may'be either a crystallizing or non-crystallizing glass at the firing conditions. Examples include borosilicate glasses such as lead borosilicate glass, zinc borosilicate glass, bismuth, cadmium, barium, calcium or other alkaline earth borosilicate glasses; and borate glasses such as zinc borate glass, zincaluminoborate glass and bismuth-lead borate glass.

The particle size and particle size distribution of the inorganic binder and any ceramic solids are not narrowly critical, and the particles will usually be between 0.5 and 20 µm in size.

### CERAMIC SOLIDS

The ceramic solids are optional in the dielectric composition of the invention. When added, they are selected to be chemically inert with respect to the other materials in the system, possess the desired electrically insulative properties and to have the appropriate physical properties relative to the inorganic binder and photosensitive components of the composition. Basically, the solids are fillers which adjust properties such as thermal expansion and dielectric constant.

The physical properties most desirable of the ceramic solids in the dielectric are (1) that they have sintering temperatures above the sintering temperatures of the inorganic binder, and (2) that they do not undergo sintering during the firing step of the invention. Thus, in the context of this invention, the term "ceramic solids" refers to inorganic materials, usually oxides, which undergo essentially no sintering and have a limited tendency to dissolve in the inorganic binder under the conditions of firing to which they are subjected in the practice of the invention.

Subject to the above criteria, virtually any high melting inorganic solid can be used as the ceramic solids component of dielectric tape. Examples include materials such as BaTiO₃, CaTiO₃, SrTiO₃, PbTiO₃, CaZrO₃, BaZrO₃, CaSnO₃, BaSnO₃, Al₂O₃, metal carbides such as silicon carbide, metal nitrides such as aluminum nitride, minerals such as mullite and kyanite, cordierite, zirconia, forsterite, anorthite, and various forms of silica. Also suitable are precursors of such materials, that is, solid materials which upon firing are converted to dielectric solids, and mixtures of any of these. Even high softening point glasses can be used as the ceramic component providing they have sufficiently high softening points. Furthermore, mixtures of such materials may be used as well.

### ORGANIC MEDIUM

### Organic Polymeric Binder

The binder polymer is critical to the compositions of the invention. It must allow for aqueous processability and at the same time afford high resolution and green strength. It has been found that these requirements are met by selecting a binder which is either (A) an organic amine-containing polymer having a pKa value of 8-12 or a mixture of organic amine containing polymers having an average pKa value of 8-12 or (B) a copolymer, interpolymer or mixture thereof, wherein each copolymer or interpolymer comprises (1) a nonacidic comonomer comprising a C₁-C₁₀ alkyl acrylate, C₁-C₁₀ alkyl methacrylate, styrene, substituted styrene, or combinations thereof and (2) an acidic comonomer comprising an ethylenically unsaturated carboxylic acid containing moiety, the copolymer, interpolymer or mixture having an acid content of at least 15% by weight. The mixture in (B) may comprise copolymers, interpolymers or both. When the binder is an organic amine-containing polymer, the developer solution must contain an acidic component. In contrast, the acidic polymer binder (B) must be developed by a solution containing a basic component.

For the acidic polymer/basic developer system, the acid functionality of the polymer binder (B) yields developability in aqueous base, such as a 0.8% to 2.0% solution of sodium or potassium carbonate. When the acid comonomer is present in concentrations of below 15%, the compositions do not wash out rapidly or adequately in aqueous base. When the acid comonomer is present in concentrations above 30% the compositions generally are unstable under humid conditions and also partially develop in the imaged areas. Suitable acidic comonomers include ethylenically unsaturated monocarboxylic acids such as acrylic, methacrylic and crotonic acids and ethylenically unsaturated dicarboxylic acids such as fumaric, itaconic, citraconic, vinyl succinic and maleic acids as well as their half esters and, where appropriate, their anhydrides and mixtures thereof.

Because they are cleaner burning in low-oxygen and substantially nonoxidizing atmospheres, methacrylic polymers are preferred over acrylic polymers when atmospheres of low oxygen potential are desired. By the term "substantially nonoxidizing atmosphere" is meant an atmosphere which contains insufficient oxygen to effect any significant oxidation of copper metal, but which nevertheless contains sufficient oxidizing material to effect oxidation of the organic materials.

It is preferred that the nonacidic comonomers constitute at least 50 and preferably 70-75 wt. % of the binder polymer. When the acidic comonomer is a half ester of an acid anhydride such as maleic anhydride it is preferred that the acidic comonomer constitute 50% by weight of the binder polymer and that the othe'r 50% be a nonacidic comonmer such as stryene or a substituted styrene. A preferred substituted styrene is alphamethyl styrene. The nonacidic portion of the polymer binder can contain up to about 50 wt. % of other nonacidic comonomers as a substitute for the alkyl acrylate, alkyl methacrylate, styrene or substituted styrene portion of the polymer. Examples include acrylonitrile, vinyl acetate and acrylamide so long as the previously discussed compositional criteria are met as well as the physical criteria mentioned below. However, it is preferred to use not more than about 25 wt. % of the total binder polymer of such monomers because they are more difficult to burn out cleanly.

It will be recognized that a single copolymer or a combination of copolymers, each of which satisfies the above criteria, may be used as the binder. In addition to the above-described copolymers, it is possible to add small amounts of other polymeric binders. Examples of these include polyolefins such as polyethylene, polypropylene, polybutylene, polyisobutylene, and ethylene-propylene copolymers; and polyethers which are polymers of lower alkylene oxides, such as polyethylene oxide.

For the amine containing polymer/acidic developer system, the amine functionality of the polymer binder (A) yields developability in aqueous organic or mineral acids, such as a 0.8-2.0% wt. solution of acetic, oxalic, lactic or citric acids. Suitable amine-containing polymers include polyethyleneimines and amine-containing acrylates and methacrylates such as 2-dimethylaminoethylacrylate and 2-dimethylaminoethylmethacrylate.

Polymers can be made by those skilled in the art of polymerization by conventional techniques. For example, acidic acrylate polymers are prepared by combining an alpha- or beta-ethylenically unsaturated acid (acidic comonomer) with one or more copolymerizable vinyl monomers (nonacidic comonomer) in a relatively low boiling (75°-150°C) organic solvent to obtain a 10 to 60% solution of the monomer mixture, then subsequently causing the monomers to polymerize by the addition of a polymerization catalyst and heating the mixture at the reflux temperature of the solution at atmospheric pressure. After the polymerization reaction is essentially complete, the resulting acid polymer solution is cooled to room temperature and samples are removed to determine the viscosity, molecular weight, acid equivalent, etc. of the polymer. Additionally, it is necessary to keep the weight average molecular weight of the acid containing binder-polymer in the range of 50,000-500,000 or greater, preferably in the range of 50,000-400,000 and more preferably 50,000-250,000.

The T_{g} of the binder polymer is greater than 50°C and preferably is in the range of 50°C-100°C. The organic polymeric binder is generally present in an amount of 4-45 percent by weight based on the total weight of the dry photopolymerizable layer.

### Photoinitiation System

Suitable photoinitiation systems are those which are thermally inactive but which generate free radicals upon exposure to actinic light at or below 85°C. These include the substituted or unsubstituted polynuclear quinones which are compounds having two intracyclic carbon atoms in a conjugated carbocyclic ring system, e.g., 9,10-anthraquinone, 2-methylanthraquinone, 2-ethylanthraquinone, 2-tert-butylanthraquinone, octamethylanthraquinone, 1,4-naphthoquinone, 9,10-phenanthrenequinone, benz(a)anthracene-7,12-dione, 2,3-naphthacene-5,12-dione, 2-methyl-1,4-naphthoquinone, 1,4-dimethylanthraquinone, 2,3-dimethylanthraquinone, 2-phenylanthraquinone, 2,3-diphenylanthraquinone, retenequinone, 7,8, 9,10-tetrahydronaphthacene-5,12-dione, and 1,2,3,4-tetrahydrobenz(a)anthracene-7,12-dione. Other photoinitiators which are also useful, even though some may be thermally active at temperatures as low as 85°C, are described in U.S. Patent 2,760,863 and include vicinal ketaldonyl alcohols such as benzoin, pivaloin, acyloin ethers, e.g., benzoin methyl and ethyl ethers; α-hydrocarbon-substituted aromatic acyloins, including α-methylbenzoin, α-allylbenzoin and α-phenylbenzoin. Photoreducible dyes and reducing agents disclosed in U.S. Patents 2,850,445, 2,875,047, 3,097,096, 3,074,974, 3,097 and 3,145,104, as well as dyes of the phenazine, oxazine, and quinone classes, Michler's ketone, ethyl Michler's ketone, benzophenone, 2,4,5-triphenylimidazolyl dimers with hydrogen donors including leuco dyes and mixtures thereof as described in U.S. Patents 3,427,161, 3,479,185 and 3,549,367 can also be used as initiators. Also useful with photoinitiators and photoinhibitors are sensitizers disclosed in U.S. Patent 4,162,162.

### Photohardenable Monomer

The photohardenable monomer component of the invention is comprised of at least one addition polymerizable ethylenically unsaturated compound having at least one polymerizable ethylenic group. Such compounds are capable of forming a high polymer by free radical initiated, chain propagating addition polymerization. The monomeric compounds are nongaseous, i.e, they have a normal boiling point above 100°C and a plasticizing action on the organic polymeric binder.

Suitable monomers which can be used alone or in combination with other monomers include t-butyl acrylate and methacrylate, 1,5-pentanediol diacrylate and dimethacrylate, N,N-diethylaminoethyl acrylate and methacrylate, ethylene glycol diacrylate and dimethacrylate, 1,4-butanediol diacrylate and dimethacrylate, diethylene glycol diacrylate and dimethacrylate, hexamethylene glycol diacrylate and dimethacrylate, 1,3-propanediol diacrylate and dimethacrylate, decamethylene glycol diacrylate and dimethacrylate, 1,4-cyclohexanediol diacrylate and dimethacrylate, 2,2-dimethylolpropane diacrylate and dimethacrylate, glycerol diacrylate and dimethacrylate, tripropylene glycol diacrylate and dimethacrylate, glycerol triacrylate and trimethacrylate, trimethylolpropane triacrylate and trimethacrylate, pentaerythritol triacrylate and trimethacrylate, polyoxyethylated trimethylolpropane triacrylate and trimethacrylate and similar compounds as disclosed in U.S. Patent 3,380,831, 2,2-di-(p-hydroxyphenyl)-propane diacrylate, pentaerythritol tetraacrylate and tetramethacrylate, 2,2-di-(p-hydroxyphenyl)-propane diacrylate, pentaerythritol tetraacrylate and tetramethacrylate, 2,2-di-(p-hydroxyphenyl)-propane dimethacrylate, triethylene glycol diacrylate, polyoxyethyl, 1,2-di-(p-hydroxyphenyl)-propane dimethacrylate, di-(3-methacryloxy-2-hydroxypropyl)ether of bisphenol-A, di-(2-methacryloxyethyl)ether of bisphenol-A, di- (3-acryloxy-2-hydroxypropyl)ether of bisphenol-A, di-(2-acryloxyethyl)ether of bisphenol-A, di-(2-acryloxyethyl) ether of bisphenol-A, di-(3-methacryloxy-2-hydroxypropyl)ether of 1,4-butanediol, triethylene glycol dimethacrylate, polyoxypropyltrimethylol propane triacrylate, butylene glycol diacrylate and dimethacrylate, 1,2,4-butanetriol triacrylate and trimethacrylate, 2,2,4-trimethyl-1,3-pentanediol diacrylate and dimethacrylate, 1-phenylethylene-1,2-dimethacrylate, diallyl fumarate, styrene, 1,4-benzenediol dimethacrylate, 1,4-diisopropenyl benzene and 1,3,5-triisopropenyl benzene. Also useful are ethylenically unsaturated compounds having a molecular weight of at least 300, e.g., alkylene or a polyalkylene glycol diacrylate prepared from an alkylene glycol of 2 to 15 carbons or a polyalkylene ether glycol of 1 to 10 ether linkages, and those disclosed in U.S. Patent 2,927,022, e.g., those having a plurality of addition polymerizable ethylenic linkages particularly when present as terminal linkages. Preferred monomers are polyoxyethylated trimethylolpropane triacrylate and methacrylate, ethylated pentaerythritol triacrylate, trimethylolpropanetriacrylates and methacrylates, dipentaerythritol monohydroxypentaacrylate and 1,10-decanediol dimethylacrylate. Other preferred monomers are monohydroxypolycaprolactone monoacrylate, polyethyleneglycol diacrylate (mol wt. 200), and polyethylene glycol 400 dimethacrylate (mol. wt. 400) . The unsaturated monomeric component is present in an amount of 1-25% by weight based on the total weight of the dry photopolymerizable layer.

### Organic Solvent

The solvent component is chosen so as to obtain complete solution of the polymer and sufficiently high volatility to enable the solvent to be evaporated from the dispersion by the application of relatively low levels of heat at atmospheric pressure. In addition, the solvent must boil well below the boiling point and decomposition temperature of any other additives contained in the organic medium. Thus, solvents having atmospheric boiling points below 150°C are used most frequently. Such solvents include acetone, xylene, methanol, ethanol, methyl ethyl ketone, 1,1,1-trichloroethane, amyl acetate, ethyl acetate, toluene and methylene chloride, and mixtures thereof.

In addition to the foregoing, the organic medium may include additives such as dispersants, polymerization inhibitors, colorants, plasticizers, release agents, stripping agents, antifouling agents and wetting agents.

A dispersant may be added to insure the efficient wetting of the inorganic materials by the organic polymers and monomers. A thoroughly dispersed inorganic is desirable in the preparation of a photoactive tape with the needed characteristics of good flexibility, green strength and complete organic burn out during firing. The dispersant acts to allow the polymeric binder(s) to associate or wet the inorganic solids, giving an agglomerate free system. The dispersants of choice are the well-known A-B dispersants generally described in "Use of A-B Block Polymers as Dispersants for Non-aqueous Coating Systems" by H. K. Jakubauskas, Journal of Coating Technology, Vol. 58; Number 736; Pages 71-82.

While it is generally desirable to include an inhibitor to prevent thermal polymerization during drying and storage, it is not absolutely essential to the photopolymerizable composition. Thermal polymerization inhibitors that can be used in photopolymerizable compositions include: p-methoxyphenol, hydroquinone, and alkyl and aryl-substituted hydroquinones and quinones, tert-butyl-catechol, pyrogallol, copper resinate, naphthylamines, beta-naphthol, cuprous chloride, 2,6-di-tert-butyl-p-cresol, phenothiazine, pyridine, nitrobenzene and dinitrobenzene, p-tolylquinone and chloranil. Also useful for thermal polymerization inhibitors are the nitroso compositions disclosed in U.S. 4,168,982.

Various dyes and pigments may be added to increase the visibility of the tape during processing. Suitable colorants will be compatible with the compositions and should preferably be transparent to the actinic radiation used. The use of organic dyes such as those designated "window dyes" and described in U.S. Patent 4,622,088 will provide a fugitive color, since they will burn out during the firing process. For permanent coloration of the material (including after firing), an inorganic pigment is preferred.

A small amount of plasticizer, relative to the binder polymer, serves to lower the glass transition temperature (Tg) of the binder polymer. However, the use of such materials should be minimized in order to reduce the amount of organic materials which must be removed when the films cast therefrom are fired. The choice of plasticizers is, of course, determined primarily by the polymer which must be modified. Among the plasticizers which have been used in various binder systems are diethyl phthalate, dibutyl phthalate, dioctyl phthalate, butyl benzyl phthalate, alkyl phosphates, polyalkylene glycols, glycerol, (poly)ethylene oxides, hydroxyethylated alkyl phenol, dialkyldithiophosphonate and (poly)isobutylene. Of course, butyl benzyl phthalate is most frequently used in acrylic polymer systems because it can be used effectively in relatively small concentrations.

The ceramic solids, inorganic binder and organic medium admixture is ultimately formulated into a green dielectric sheet. One method for forming such tape comprises casting the composition onto a flexible substrate, such as a steel belt or polymeric film, then heating the cast layer to remove the volatile organic solvent. Most often, the flexible substrate is a polymeric film and the composition is cast, heated and stored on the film.

Multilayer interconnect circuits including such features as circuit lines, capacitors and resistors are fabricated from the dielectric sheets and the appropriate conductive and resistive compositions. To do this, first the dielectric sheet is imagewise exposed to actinic radiation through an image of the desired pattern of holes such as vias and cavities; which penetrate completely through the sheet, and recesses where such features as circuit lines, resistors and capacitors, will penetrate partially through the sheet. These different pattern elements are formed by controlling the duration or intensity of exposure and exposing one or both sides of each sheet to the same or different patterns. It is necessary to expose both sides of the sheet in those cases where a recess is being formed in the sheet. For example, if a pattern of holes is desired, a sheet of the invention can be exposed on one side for 4-8 seconds or each side can be exposed to complementary, aligned images of the same pattern for 2-4 seconds. If a mixed pattern of holes and recesses (vias and circuit lines for example) is desired, one side of a sheet is exposed to an image of the pattern for both the holes and recesses for 1-7 seconds. The opposite side of the sheet is exposed to a complementary, aligned image of the same holes pattern for 1-7 seconds. It will be obvious to those skilled in the art of photopolymerization that the depth of the recesses that can be formed in the sheet by this process can be controlled or changed by varying the level of exposure given to each side of the sheet. Increasing the exposure given to the side opposite that of the recess will provide a shallower recess in the dielectric and conversely, decreasing the exposure level given to the side of the sheet opposite the recess will increase the depth of the recess in the sheet.

The exposed sheet is developed in a dilute aqueous solution. Exposure changes the solubility of the exposed portions of the photosensitive dielectric sheet and development removes the unexposed and unpolymerized material from the hole (via and cavity) and recess patterns. As discussed previously, the developer is a dilute aqueous caustic solution when the organic polymeric binder in the dielectric sheet is an acidic polymer (B), and a dilute aqueous acidic solution when the organic polymeric binder is the amine-containing polymer (A). The sheet can be treated with developer by conventional methods such as dipping, brushing and spraying. Owing to the superior green strength of the dielectric sheet due to the formation of the three dimensional polymer network during photopolymerization, the present dielectric sheets can also be developed by spraying the appropriate solution under 0.69-2.41 bar (10-35 psi) force at a sheet on a screen mesh or other such porous support. Following treatment with developer, the sheet is normally rinsed with tap water or preferably deionized water.

The developed sheet is then dried in preparation for further handling and processing. Blowing air across the developed sheet, and heating the sheet in an oven, for example, are suitable drying methods as are any other conventional method that does not detrimentally effect the properties of the sheet. Typically, temperatures in the range of 40-120°C are suitable.

To build the layers for a multilayer interconnect circuit, the vias holes in an appropriately patterned dielectric sheet are metallized with a conductive composition. Suitable compositions, including thick film compositions and conductive sheet compositions are readily available and well-known. Silver, gold, copper, palladium, platinum and mixtures thereof are common conductive metals in such compositions.

If the dielectric sheet includes a patterned recess on either or both sides, the recess is metallized with the appropriate conductive or resistive composition. Metallization can be achieved by any number of methods. For example, a metallic composition can be screen printed into the recess or a metallic composition can be appropriately applied to the surface of another dielectric sheet which is subsequently aligned with the recess pattern. Recessed patterns allow components such as capacitors and resistors and any circuitry lines to lie within rather than on top of the dielectric sheets within the multilayer circuit. This achieves a smoother surface topography for the multilayer circuit. Attachment to the surface of the multilayer circuit is easier and more reliable with the smoother surface.

Generally, a patterned electrically functional layer containing the appropriate resistive and conductive compositions is applied to the surface of the dielectric sheet in registry with the vias and cavities, if any, and patterned recesses, if any. If desired, the vias and recesses can be metallized and the patterned electrically functional layer applied in the same step. Likewise, the vias and recesses may be metallized in one step with the patterned functional layer being applied in another step.

As the ordinary artisan in this field well knows, the design of multilayer interconnect circuits varies quite significantly, depending upon the electrical functionality and physical size and shape requirements for the application. By exposing, developing, drying and metallizing the appropriate number of dielectric sheets with the appropriate patterns of holes and recesses, the desired interconnect circuit can be assembled.

Typically, the patterned sheets with the desired metallization are stacked and laminated forming a green monolith. A single assemblage can also be formed layer by layer, but this process is more time consuming and suffers from lower yields.

After the monolith is assembled, it is fired. Firing can be accomplished in either a one or two step process. A one step process will normally use an extended belt furnace, while a two step process may employ a programmable box furnace for organic burnout and a conventional thick film furnace for firing. Firing times and temperatures should be optimized for the desired physical properties and the inorganic binders and ceramic solids used in the composition. For instance, in the following examples, burnout and firing was accomplished in one step in a 12 zone furnace. The monoliths experienced a temperature ramping rate of 10°C per minute and were held between 200°C and 500°C for one hour. The temperature was then increased to 850°C and the samples were held at that temperature for approximately 20 minutes and then cooled. The total time above 600°C was approximately 48 minutes, and the entire burnout and firing cycle required over 3 hours. These times and temperatures should be adjusted to match the ceramic solids and inorganic binders used in the composition.

Using the photosensitive dielectric sheets of the invention, holes can be formed in the sheet at rates up to 5,000 holes/second, recesses can be formed, cavities and recesses can be formed simultaneously with vias and vias as small as 0.10 mm (4 mils) in diameter in 0.10 mm (4 mil) thick tape can be reliably and reproducibly resolved.

### EXAMPLES

The following materials were used in the Examples in the amounts specified below. All percentages are by weight unless indicated otherwise.

### Ceramic Solids

Quartz in a silica powder with a 50% PSD (Particle Size Distribution) of 2.0-2.4µm.

Alumina was as aluminum oxide powder containing particles having a surface area of 7.4-9.0 m²/g.

### Inorganic Binder

Glass frit was a lead borosilicate glass powder composed of 56.5% SiO₂, 17.2% PbO, 9.1% Al₂O₃, 8.0% CaO, 4.5% B₂O₃, 2.4% Na₂O, 1.7% K₂O and 0.6% MgO, the particles having a surface area of 3.8-4.6 m²/g.

### Organic Polymeric Binder

Binder I was a copolymer of 44% methyl methacrylate (MMA), 35% ethyl acrylate (EA), and 21% methacrylic acid (MAA), M_{w} = 50,000, Tg = 87°C and Acid No.=120.

Binder II was a copolymer of 41% MMA, 38% EA and 21% MAA, M_{w} = 65,000, Tg = 98°C and Acid Number = 120.

Binder III was a copolymer of 38% MMA, 38% EA and 24% MAA, M_{w} = 57,000, Tg = 91°C and Acid Number = 145.

Binder IV was a copolymer of 37% MMA, 55% EA and 8% MAA, Mw-250,000, Tg=35°C and Acid Number=85.

Binder V was a copolymer of 75% MMA and 25% MAA, Mw=6,100, Tg=110°C and Acid Number=155.

Binder VI was a copolymer of 20% Styrene (Sty), 21% MMA, 38% EA, 21% MAA, Mw=65,000, Tg=80°C and Acid No.=135.

### Photoinitiator

Benzophenone, Michler's Ketone (4,4'-bis(dimethylamino)benzophenone) and Ethyl Michler's Ketone (4,4'-bis (diethylamino)benzophenone).

### Photohardenable Monomer

TMPTA was trimethylolpropane triacrylate
TEOTA-1000 was ethoxylated trimethylolpropane triacrylate, M_{w} = 1000.
TMPEOTA was ethoxylated trimethylolpropane triacrylate, Mw=428.

### Solvent

Methyl ethyl ketone; 1,1,1-trichloroethane, ethyl acetate and methanol.

### Inhibitor

Ionol was 2,6-di-tert-butyl-4-methylphenol.

### Dispersant

Pluronic 3lRl was an A-B-A block copolymer of polypropylene and polyethylene oxides with a Mw-3,200.

### Example 1

Dielectric composition in parts by weight (pbw):

| | |
|---|---|
| Quartz | 8.18 |
| Alumina | 33.30 |
| Glass frit | 65.18 |
| Binder II | 9.16 |
| Benzophenone | 0.92 |
| Michler's Ketone | 0.18 |
| TEOTA-1000 | 3.18 |
| TMPTA | 0.80 |
| Methyl Ethyl Ketone | 30.00 |
| 1,1,1-trichloroethane | 60.00 |
| Ionol | 0.06 |
| | Total 210.96 |

The organic polymeric binder, photoinitiator, photohardenable monomer, inhibitor, organic solvent, ceramic solids and inorganic binder were weighed and added to a Number 00 ball mill jar containing 1360 g of Zirconium media. The mixture was milled for 16 hours to dissolve and/or disperse the ingredients. The dispersion was removed from the mill jar and cast onto a flexible polyester sheet using a doctor knife with a 0.51 mm (20 mil) gap. The coating was dried at room temperature for more than 2 hours and then tested. The coating exhibited some mud cracking, when dried. The dried dielectric sheet exhibited good flexibility, when tested by bending. The sheet was exposed to actinic radiation on one side, for various times (1 - 30 secs), through a pattern image containing 0.64, 0.25, 0.20, 0.15 and 0.10 mm (25, 10, 8, 6 and 4 mil) vias. The sheet was then developed in an aqueous 0.8% Na₂CO₃ solution at 85°C. The 0.25 mm (10 mil) vias were resolved during development.

### Example 2

Example 1 was repeated except a doctor knife gap of 0.38 mm (15 mils) was used to form the dielectric sheet. The dried dielectric sheet showed good flexibility when bent, and 0.25 mm (10 mil) vias were resolved when the sheet was exposed and developed in the same manner as Example 1.

### Example 3

Example 1 was repeated with the following composition in pbw:

| | |
|---|---|
| Quartz | 8.18 |
| Alumina | 33.30 |
| Glass frit | 65.18 |
| Binder I | 9.16 |
| Benzophenone | 0.92 |
| Michler's Ketone | 0.18 |
| TEOTA-1000 | 3.18 |
| TMPTA | 0.80 |
| Methyl ethyl ketone | 30.00 |
| 1,1,1-trichloroethane | 60.00 |
| Ionol | 0.06 |
| | Total 210.96 |

The coating exhibited some mud cracking, when dried. The dried dielectric sheet exhibited a slight brittleness, when tested by bending. The sheet was exposed to actinic radiation on one side, for various times (1 - 30 secs), through a pattern image containing 0.64, 0.25, 0.20, 0.15 and 0.10 mm (25, 10, 8, 6 and 4 mil) vias. The sheet was then developed in an aqueous 0.8% Na₂CO₃ solution at 85°C. The (10 mil) vias were resolved during development.

### Example 4

Dielectric composition in pbw:

| | |
|---|---|
| Quartz | 8.18 |
| Alumina | 33.30 |
| Glass frit | 65.18 |
| Binder III | 14.00 |
| Benzophenone | 2.08 |
| Ethyl Michler's Ketone | 0.40 |
| TEOTA-1000 | 14.18 |
| TMPTA | 3.53 |
| Ethyl Acetate | 75.20 |
| Methanol | 5.00 |
| Ionol | 0.10 |
| | Total 221.15 |

The organic polymeric binder, photoinitiator, photohardenable monomers, inhibitor and the organic solvents were added to a clear glass jar and stirred until all the materials had dissolved, forming a solution. The ceramic solids and inorganic binder were added to a Number 00 mill jar, with 1350 grams of Zirconium media and rolled for 1 hour to mix the inorganic materials. The mill jar was opened, and the solution of organic components formed earlier was poured into the mill jar and rolling continued for 16 hrs. to form the dispersion. After milling, the dispersion was strained from the media and cast onto a flexible polyester sheet using a doctor knife with a 0.51 mm (20 mil) gap. The coating was dried at room temperature for more than 2 hours and then tested. The 0.13 (5 mil) thick dried coating exhibited very slight mud cracking. The dried dielectric sheet exhibited good flexibility, when tested by bending. The sheet was exposed to actinic radiation on one side, for various times (1 - 15 s), through a pattern image containing 0.64, 0.25, 0.20, 0.15 and 0.10 mm (25, 10, 8, 6 and 4 mil) vias. The sheet was then developed in an aqueous 0.85% Na₂CO₃ solution at 85°C. The 0.20 mm (8 mil) vias were resolved during development, at exposures of 4-6 seconds.

### Example 5

Example 4 was repeated using a 0.38 mm (15 mil) doctor knife gap to provide a dried coating thickness of 0.107 mm (4.2 mils). The physical properties of the coating were similar. 0.15 (6 mil) vias were resolved during development with exposures of 4-5 seconds.

### Example 6

Example 4 was repeated, using 12.00 pbw Binder III. The 0.13 mm (5 mil) thick dried coating exhibited very slight mud cracking. The dried dielectric sheet exhibited good flexibility, when tested by bending. The sheet was exposed to actinic radiation on one side, for various times (1 - 15 s), through a pattern image containing 0.64, 0.25, 0.20, 0.15 and 0.10 mm (25, 10, 8, 6 and 4 mil) vias. The sheet was then developed in an aqueous 0.85% Na₂CO₃ solution at 85°C. The 0.20 mm (8 mil) vias were resolved during development, at exposures of 4-6 seconds.

### Example 7

Example 4 was repeated, using a 0.64 mm (25 mil) doctor knife gap to provide a 0.15 mm (6 mil) dried coating. The dielectric exhibited good flexibility and 0.25 mm (10 mil) vias were resolved using exposures of 4 - 10 seconds and development in the 0.85% aqueous sodium carbonate solution.

### Example 8

The composition of Example 4 was prepared in a larger batch size of 4338.2 g.. The organic components were predissolved and then added to a 11.4 1 (3 gal) mill jar, containing 50% by jar volume Zirconium media and the inorganic binders and ceramic particles that had been pre-dispersed by roll milling for 1 h. Milling was continued for an additional 16 hours to disperse all the components and form the slip (final dispersion). After milling, the slip was strained through 140 mesh nylon filter cloth. The slip was coated on flexible polyester using a mechanical coater equipped with a doctor knife coating head. A coating speed of 61 cm (2 feet) per minute was used, with a drying temperature of 60-74°C (140-165°F). The doctor knife was adjusted to obtain a dry coating thickness of approximately 0.10 mm (4 mils). The coating quality of the dielectric was very good, with a smooth uniform surface free of mud cracking. The dielectric was flexible, when bent and demonstrated a tensile strength greater than 41.4 bar (600 psi) and an elongation greater than 14%.

The dielectric sheet was exposed to actinic radiation on one side, for various energy levels (10 - 90 mJ/cm²), through a pattern image containing 0.64, 0.25, 0.20, 0.15 and 0.10 mm (25, 10, 8, 6 and 4 mil) vias. The sheet was then developed in an aqueous 0.85% Na₂CO₃ solution at 85°C and dried in a warm air turbine dryer. The 0.15 mm (6 mil) vias were cleanly resolved during development, at an energy level of approximately 55 mJ/cm². Large via array patterns were formed by exposing dielectric sheets to 40 - 70 mJ/cm² of actinic radiation on one side, with 1 to 4 pattern images containing more than 160,000 0.20 mm (8 mil) vias on 0.391 mm (15.4 mil) centers per pattern, developing and drying the parts in a warm air turbine dryer. The dielectric sheet with 4 pattern images, for a total of more than 640,000 vias, was exposed to actinic radiation and developed and dried in about 2 minutes.

Dielectric sheets were also exposed to actinic radiation on both sides, for various energy levels (10 - 50 mJ/cm²), developed on a porous support and then dried. Exposures of 20 mJ/cm² cleanly resolved 4 mil vias in the dielectric sheet. Vias and recesses were simultaneously formed in dielectric sheets by exposing the sheets to 30 - 40 mJ/cm² of actinic radiation on both sides, with via and line patterns, and developing the sheets on porous supports.

Single dielectric sheets and laminated monoliths of 4 and 9 layers, without metalization, were fired in a one-step extended 12-zone furnace, under the conditions described above, to produce ceramic substrates.

### Example 9

The composition of Example 6 was prepared in a larger batch size of 4350.2 g. The organic components were predissolved and then added to a 11.4 l (3 gal) mill jar, containing 50% by jar volume Zirconium media and the inorganic binders and ceramic particles that had been pre-dispersed by roll milling for 1 h. Milling was continued for an additional 16 hours to disperse all the components and form the slip (final dispersion). After milling, the slip was strained through 140 mesh nylon filter cloth. The slip was coated on flexible polyester using a mechanical coater equipped with a doctor knife coating head. A coating speed of 61 cm (2 feet) per minute was used, with a drying temperature of 60-74°C (140-165°F). The doctor knife was adjusted to obtain a dry coating thickness of approximately 0.107 mm (4.2 mils). The coating quality of the dielectric was very good, with a smooth uniform surface free of mud cracking. The dielectric was flexible, when bent and demonstrated a tensile strength greater than 37.9 bar (550 psi) and an elongation greater than 13%.

The dielectric sheet was exposed to actinic radiation on one side, for various energy levels (10 - 90 mJ/cm²), through a pattern image containing 0.64, 0.25, 0.20, 0.15 and 0.10 mm (25, 10, 8, 6 and 4 mil) vias. The sheet was then developed in an aqueous 0.85% Na₂CO₃ solution at 85°C and dried in a warm air turbine dryer. The 0.15 mm (6 mil) vias were cleanly resolved during development, at an energy level of approximately 65 mJ/cm². Large via array patterns were formed by exposing dielectric sheets to 40 - 70 mJ/cm² of actinic radiation on one side, with 1 to 4 pattern images containing more than 160,000 0.20 mm (8 mil) vias on 0.391 mm (15.4 mil) centers per pattern, developing and drying the parts in a warm air turbine dryer. The dielectric sheet with 3 pattern images, for a total of more than 480,000 vias, was exposed to actinic radiation and developed and dried in about 2 minutes.

### Example 10

Dielectric composition in pbw:

| | |
|---|---|
| Quartz | 155.4 |
| Alumina | 632.7 |
| Glass Frit | 1238.4 |
| Binder III | 152.0 |
| Binder IV | 38.0 |
| Benzophenone | 39.5 |
| Ethyl Michler's Ketone | 7.6 |
| TMPEOTA | 332.5 |
| Ionol | 3.1 |
| Ethyl Acetate | 1607.0 |
| Methanol | 106.0 |
| | Total 4312.2 |

The organic components were predissolved and then added to a 11.4 l (3 gal) mill jar, containing 50% by jar volume Zirconium media and the inorganic binders and ceramic particles that had been predispersed by roll milling for 1 h. Milling was continued for an additional 16 hours to disperse all the components and form the slip (final dispersion). After milling, the slip was strained through 140 mesh nylon filter cloth. The slip was coated on flexible polyester using a mechanical coater equipped with a doctor knife coating head. A coating speed of 61 cm (2 feet) per minute was used, with a drying temperature of 60-74°C (140-165°F). The doctor knife was adjusted to obtain a dry coating thickness of approximately 0.102 mm (4.0 mils). The coating quality of the dielectric was fair, with a small amount of mud cracking. The dielectric was flexible, when bent and demonstrated a tensile strength greater than 13.8 bar (200 psi) and an elongation greater than 2%.

The dielectric sheet was exposed to actinic radiation on one side, for 55 mJ/cm², through a pattern image containing 0.20 mm (8 mil) vias. The sheet was then developed in an aqueous 0.85% Na₂CO₃ solution at 85°C and dried in a warm air turbine dryer. The 0.20 mm (8 mil) vias were cleanly resolved during development.

### Example 11

The composition of Example 6, with the addition of 2 pbw of Pluronic® 3lRl, was prepared by the same milling procedure as Example 6 and then cast onto a flexible polyetherimide sheet, using a doctor knife on a small mechanical coater. The coating was dried on the heated drum at 66°C (150°F). The 0.137 mm (5.4 mil) coating did not show mud cracking, and was flexible when bent. The sheet was exposed to actinic radiation, on one side, for various lengths of time (2-10 seconds), through a pattern image containing 0.64, 0.25, 0.20, 0.15 and 0.10 mm (25, 10, 8, 6 and 4 mil) vias. The sheet was then developed in an aqueous 0.85% Na₂CO₃ solution at 85°C.
The 0.15 and 0.20 mm (6 and 8 mil) vias were resolved at 4 and 6 seconds, respectively.

### Example 12

The composition of Example 4, with Binder VI replacing Binder III was prepared, cast and processed in the same manner as Example 11. The 0.135 mm (5.3 mil) coating was of good quality, with no mud cracking and demonstrated good flexibility when bent. Under the same exposure and development conditions used in Example 11, 0.20 mm (8 mil) vias were cleanly resolved at exposures of 6, 8 and 10 seconds.

### Example 13

| Dielectric composition in pbw: | |
|---|---|
| Quartz | 8.2 |
| Alumina | 33.3 |
| Glass Frit | 65.2 |
| Binder VI | 10.0 |
| Binder V | 4.0 |
| Benzophenone | 2.1 |
| Ethyl Michler's Ketone | 0.4 |
| TMPTA | 3.5 |
| TEOTA-1000 | 14.2 |
| Ionol | 0.1 |
| Ethyl Acetate | 75.2 |
| Methanol | 5.0 |
| Total | 221.2 |

The composition was prepared, cast and processed in the same manner as Example 11. The 0.160 mm (6.3 mil) coating was flexible, with no mud cracking. 0.64 (25 mil) vias were cleanly resolved at exposures ranging from 4 to 10 seconds.

## Claims

1. A castable, photosensitive self-supporting dielectric sheet composition, said composition comprising
an admixture of:
(a) finely divided particles of an inorganic binder, and
(b) optionally finely divided particles of ceramic solids;
dispersed in an organic medium containing:
(c) an organic polymeric binder comprising an amine-containing organic polymer or a copolymer, an interpolymer or mixtures thereof, each copolymer or interpolymer comprising (1) a nonacidic comonomer of C₁-C₁₀ alkyl acrylate, C₁-C₁₀ alkyl methacrylate, styrene, substituted styrene or combination thereof and (2) an acidic comonomer comprising an ethylenically unsaturated carboxylic acid containing moiety, the copolymer interpolymer or mixture having an acid content of at least 15% by weight of the total polymer weight, and the weight average molecular weight of the binder being in the range of 50,000-500,000 or greater and the average glass transition temperature of the binder being in the range of 50°-100°C, and
(d) a photoinitiator dissolved in
(e) photohardenable monomer, and
(f) an organic solvent,
the composition upon imagewise exposure to actinic radiation being developable in a dilute aqueous acidic or caustic solution containing 0.8-2.0% by weight acid or base.

2. The composition of claim 1 wherein the weight average molecular weight of the organic polymeric binder or mixture of polymeric binders is in the range of 50,000 to 400,000.

3. The composition of claim 2 wherein the weight average molecular weight of the organic polymeric binder or mixture of polymeric binders is in the range of 50,000 to 250,000.

4. The composition of claim 1 wherein the organic polymeric binder is a copolymer or interpolymer or mixtures thereof, each copolymer or interpolymer comprising (1) a nonacidic comonomer of C₁-C₁₀ alkyl acrylate, C₁-C₁₀ alkyl methacrylate, styrene, substituted styrene or combination thereof and (2) an acidic comonomer comprising an ethylenically unsaturated carboxylic acid containing moiety, the copolymer, interpolymer or mixture having an acid content of at least 15% by weight of the total polymer weight.

5. The composition of claim 4 wherein the organic polymeric binder moieties derived from the unsaturated carboxylic acid are not greater than 30 percent by weight of the binder.

6. The composition of claim 5 wherein the organic polymeric binder is a terpolymer of methylmethacrylate, ethylacrylate and methacrylic acid.

7. A photosensitive self-supporting green dielectric sheet comprising
an admixture of:
(a) finely divided particles of an inorganic binder, and
(b) optionally finely divided particles of ceramic solids;
dispersed in an organic medium containing:
(c) an organic polymeric binder comprising an amine-containing organic polymer or a copolymer, an interpolymer or mixtures thereof, each copolymer or interpolymer comprising (1) a nonacidic comonomer of C₁-C₁₀ alkyl acrylate, C₁-C₁₀ alkyl methacrylate, styrene, substituted styrene or combination thereof and (2) an acidic comonomer comprising an ethylenically unsaturated carboxylic acid containing moiety, the copolymer interpolymer or mixture having an acid content of at least 15% by weight of the total polymer weight, and the weight average molecular weight of the binder being in the range of 50,000-500,000 or greater and the average glass transition temperature of the binder being in the range of 50°-100°C, and
(d) a photoinitiator dissolved in
(e) photohardenable monomer
the composition upon imagewise exposure to actinic radiation being developable in a dilute aqueous acidic or caustic solution containing 0.8-2.0% by weight acid or base.

8. The dielectric sheet of claim 7 wherein the weight average molecular weight of the organic polymeric binder or mixture of polymeric binders is in the range of 50,000 to 400,000.

9. The dielectric sheet of claim 8 wherein the weight average molecular weight of the organic polymeric binder or mixture of polymeric binders is in the range of 50,000 to 250,000.

10. The dielectric sheet of claim 7 wherein the organic polymeric binder contains a copolymer or interpolymer or mixtures thereof, each copolymer or interpolymer comprising (1) a nonacidic comonomer of C₁-C₁₀ alkyl acrylate, C₁-C₁₀ alkyl methacrylate, styrene, substituted styrene or combination thereof and (2) an acidic comonomer comprising an ethylenically unsaturated carboxylic acid containing moiety, the copolymer, interpolymer or mixture having an acid content of at least 15% by weight of the total polymer weight.

11. The dielectric sheet of claim 10 wherein the organic polymeric binder moieties derived from the unsaturated carboxylic acid are not greater than 30 percent by weight of the binder.

12. The dielectric sheet of claim 11 wherein the organic polymeric binder is a terpolymer of methylmethacrylate, ethylacrylate and methacrylic acid.

13. A method for making a multilayer interconnect using a photosensitive self-supporting dielectric sheet of claim 7 comprising the sequential steps of:
(a) imagewise exposing the dielectric sheet to actinic radiation through an image of a via pattern and optionally, a cavity pattern;
(b) developing the exposed sheet in a dilute aqueous acidic or caustic solution containing 0.8-2.0% by weight acid or base to form a patterned array of vias and optionally cavities;
(c) drying the developed sheet;
(d) metallizing the vias with a conductive composition;
(e) optionally applying to the dielectric sheet a patterned electrically functional layer in registry with the via pattern and any cavities in the sheet;
(f) repeating steps (a) through (e) with the desired via, cavity and electrically functional pattern until the desired number of layers have been formed;
(g) laminating the layers from step (f) to form an assemblage of interconnected electrically functional layers separated by dielectric material; and
(h) cofiring the assemblage of step (g).

14. The method of claim 13 wherein the imagewise exposed dielectric sheet is developed and dried on a porous support.

15. A method for making a multilayer interconnect circuit using a photosensitive self-supporting dielectric sheet of claim 7 comprising the sequential steps of:
(a) imagewise exposing both sides of the self-supporting photosensitive dielectric sheet to actinic radiation through a matched and aligned pair of images of a via pattern and optionally, a cavity pattern;
(b) developing the exposed sheet in a dilute aqueous acidic or caustic solution containing 0.8-2.0% by weight acid or base to form a patterned array of vias and optionally cavities;
(c) drying the developed sheet;
(d) metallizing the vias with a conductive composition;
(e) optionally applying to the dielectric sheet a patterned electrically functional layer in registry with the via pattern and any cavities in the sheet;
(f) repeating steps (a) through (e) with the desired via, cavity and electrically functional patterns until the desired number of layers have been formed;
(g) laminating the layers from step (f) to form an assemblage of interconnected electrically functional layers separated by dielectric material; and
(h) cofiring the assemblage of step (g).

16. The method of claim 15 wherein
one side of at least one of the photosensitive dielectric sheets is imagewise exposed in step (a) through an image comprising a via and optionally, a cavity pattern, and a pattern for another electrically functional feature, the opposite side of the sheet being exposed through a matched and aligned image of said via and optional cavity pattern;
development in step (b) of said sheet to form a patterned array of vias and optionally, cavities through the sheet and a patterned recess in the shape of an electrically functional feature in one side of the sheet; and
the patterned recess is metallized with a conductive or resistive composition.

17. The method of claim 16 wherein
in step (a) the opposite side of at least one photosensitive dielectric sheet is exposed through a matched and aligned image comprising the same via and cavity pattern, and further comprising a pattern for another electrically feature; and
upon development in step (b) of said sheet a patterned array of vias and optionally, cavities is formed through the sheet and a patterned recess in the shape of an electrical feature is formed in each side of the sheet.

18. The method of claims 15, 16 or 17 wherein the imagewise exposed dielectric sheet is developed and dried on a porous support.

19. The method of claims 15, 16 or 17 wherein each side of the dielectric sheet is imagewise exposed in turn in step (b) through the appropriate image of a matched and aligned set of images.

20. The method of claims 15, 16 or 17 wherein both sides of the dielectric sheet are imagewise exposed simultaneously in step (b) through a matched and aligned pair of images.

21. The method of any claims 13-20 further comprising:
(i) applying to one or both of the outermost surfaces of the fired assemblage a patterned electrically functional layer in registry with the via pattern and any cavities therein;
(j) firing the structure from step (i).
(k) repeating steps (i) and (j) as many times as necessary to form the desired outer layer circuit pattern(s).

## Patentansprüche

1. Gießbare Zusammensetzung für eine lichtempfindliche, selbsttragende, dielektrische Folie, wobei die Zusammensetzung eine Mischung umfaßt von:
(a) fein zerteilten Teilchen eines anorganischen Bindemittels und
(b) gegebenenfalls fein zerteilten Teilchen keramischer Feststoffe, die in einem organischen Medium dispergiert sind, enthaltend:
(c) ein organisches, polymeres Bindemittel, umfassend ein ein Amin enthaltendes, organisches Polymer oder Copolymer, ein Interpolymer oder Mischungen derselben, wobei jedes Copolymer oder Interpolymer umfaßt: (1) ein nichtsaures C₁-C₁₀-Alkylacrylat-, C₁-C₁₀-Alkylmethacrylat-, Styrol-, substituiertes Styrol-Comonomer oder eine Kombination derselben und (2) ein saures Comonomer, umfassend einen Rest, der eine ethylenisch ungesättigte Carbonsäure enthält, wobei das Copolymer, das Interpolymer oder eine Mischung derselben einen Säuregehalt von wenigstens 15 Gew.-% der gesamten Polymermasse aufweist und das Massenmittel der Molmasse des Bindemittels im Bereich von 50 000 bis 500 000 oder höher liegt und die durchschnittliche Glasübergangstemperatur des Bindemittels im Bereich von 50 °C bis 100 °C liegt, und
(d) einen Photoinitiator, gelöst in
(e) einem photohärtbaren Monomer und
(f) einem organischen Lösungsmittel,
wobei die Zusammensetzung bei der bildweisen Belichtung mit aktinischer Strahlung in einer verdünnten, wäßrigen, sauren oder alkalischen, 0,8 Gew.-% bis 2,0 Gew.-% Säure oder Base enthaltenden Lösung entwickelbar ist.

2. Zusammensetzung gemäß Anspruch 1, worin das Massenmittel der Molmasse des organischen, polymeren Bindemittels oder der Mischung von polymeren Bindemitteln im Bereich von 50 000 bis 400 000 liegt.

3. Zusammensetzung gemäß Anspruch 2, worin das Massenmittel der Molmasse des organischen, polymeren Bindemittels oder der Mischung von polymeren Bindemitteln im Bereich von 50 000 bis 250 000 liegt.

4. Zusammensetzung gemäß Anspruch 1, worin das organische, polymere Bindemittel ein Copolymer oder ein Interpolymer oder Mischungen derselben ist, wobei jedes Copolymer oder Interpolymer umfaßt: (1) ein nichtsaures C₁-C₁₀-Alkylacrylat-, C₁-C₁₀-Alkylmethacrylat-, Styrol-, substituiertes Styrol-Comonomer oder Mischungen derselben und (2) ein saures Comonomer, umfassend einen Rest, der eine ethylenisch ungesättigte Carbonsäure enthält, wobei das Copolymer, das Interpolymer oder eine Mischung derselben einen Säuregehalt von wenigstens 15 Gew.-% des gesamten Polymergewichts aufweist.

5. Zusammensetzung gemäß Anspruch 4, worin die organischen, polymeren Bindemittel-Reste, die sich von der ungesättigten Carbonsäure ableiten, nicht mehr als 30 Gew.-% des Bindemittels ausmachen.

6. Zusammensetzung gemäß Anspruch 5, worin das organische, polymere Bindemittel ein Terpolymer von Methylmethacrylat, Ethylacrylat und Methacrylsäure ist.

7. Lichtempfindliche, selbsttragende, dielektrische Grün-Folie, umfassend eine Mischung von:
(a) fein zerteilten Teilchen eines anorganischen Bindemittels und
(b) gegebenenfalls fein zerteilten Teilchen keramischer Feststoffe, die in einem organischen Medium dispergiert sind, enthaltend:
(c) ein organisches, polymeres Bindemittel, umfassend ein ein Amin enthaltendes, organisches Polymer oder Copolymer, ein Interpolymer oder Mischungen derselben, wobei jedes Copolymer oder Interpolymer umfaßt: (1) ein nichtsaures C₁-C₁₀-Alkylacrylat-, C₁-C₁₀-Alkylmethacrylat-, Styrol-, substituiertes Styrol-Comonomer oder eine Kombination derselben und (2) ein saures Comonomer, umfassend einen Rest, der eine ethylenisch ungesättigte Carbonsäure enthält, wobei das Copolymer, das Interpolymer oder eine Mischung derselben einen Säuregehalt von wenigstens 15 Gew.-% der gesamten Polymermasse aufweist und das Massenmittel der Molmasse des Bindemittels im Bereich von 50 000 bis 500 000 oder höher liegt und die durchschnittliche Glasübergangstemperatur des Bindemittels im Bereich von 50 °C bis 100 °C liegt, und
(d) einen Photoinitiator, gelöst in
(e) einem photohärtbaren Monomer,
wobei die Zusammensetzung bei der bildweisen Belichtung mit aktinischer Strahlung in einer verdünnten, wäßrigen, sauren oder alkalischen, 0,8 Gew.-% bis 2,0 Gew.-% Säure oder Base enthaltenden Lösung entwickelbar ist.

8. Dielektrische Folie gemäß Anspruch 7, worin das Massenmittel der Molmasse des organischen, polymeren Bindemittels oder einer Mischung von polymeren Bindemitteln im Bereich von 50 000 bis 400 000 liegt.

9. Dielektrische Folie gemäß Anspruch 8, worin das Massenmittel der Molmasse des organischen, polymeren Bindemittels oder einer Mischung von polymeren Bindemitteln im Bereich von 50 000 bis 250 000 liegt.

10. Dielektrische Folie gemäß Anspruch 7, worin das organische, polymere Bindemittel ein Copolymer oder Interpolymer oder eine Mischung derselben enthält, wobei jedes Copolymer oder Interpolymer umfaßt: (1) ein nichtsaures C₁-C₁₀-Alkylacrylat-, C₁-C₁₀-Alkylmethacrylat-, Styrol-, substituiertes Styrol-Comonomer oder eine Kombination derselben und (2) ein saures Comonomer, umfassend einen Rest, der eine ethylenisch ungesättigte Carbonsäure enthält, wobei das Copolymer, das Interpolymer oder eine Mischung derselben einen Säuregehalt von wenigstens 15 Gew.-% des gesamten Polymergewichts aufweist.

11. Dielektrische Folie gemäß Anspruch 10, worin die organischen, polymeren Bindemittel-Reste, die sich von der ungesättigten Carbonsäure ableiten, nicht mehr als 30 Gew.-% des Bindemittels ausmachen.

12. Dielektrische Folie gemäß Anspruch 10, worin das organische, polymere Bindemittel ein Terpolymer von Methylmethacrylat, Ethylacrylat und Methacrylsäure ist.

13. Verfahren zur Herstellung einer Mehrschichten-Zwischenverbindung unter Verwendung einer lichtempfindlichen, selbsttragenden, dielektrischen Folie gemäß Anpruch 7, umfassend die aufeinanderfolgenden Stufen:
(a) der bildweisen Belichtung der dielektrischen Folie mit aktinischer Strahlung durch ein Bild eines Kontaktlochmusters und gegebenenfalls eines Hohlraummusters;
(b) der Entwicklung der belichteten Folie in einer verdünnten, wäßrigen, sauren oder basischen Lösung, die 0,8 bis 2,0 Gew.-% Säure oder Base enthält, um eine gemusterte Anordnung von Durchgangslöchern und gegebenenfalls Hohlräumen zu bilden;
(c) des Trocknens der entwickelten Folie;
(d) des Metallisierens der Durchgangslöcher mit einer leitfähigen Zusammensetzung;
(e) des wahlweisen Auftragens einer gemusterten, elektrisch-funktionellen Schicht auf die dielektrische Folie in paßgenauer Übereinstimmung mit dem Kontaktlochmuster und allen Hohlräumen in der Folie;
(f) des Wiederholens der Stufen (a) bis (e) mit dem erwünschten Durchgangsloch, dem Hohlraum und dem elektrisch-funktionellen Muster, bis die erwünschte Anzahl von Schichten gebildet worden ist;
(g) des Laminierens der Schichten der Stufe (f), um eine Anordnung von untereinander verbundenen, elektrisch-funktionellen Schichten zu bilden, die durch das dielektrische Material getrennt sind; und
(h) des gemeinsamen Brennens der Anordnung der Stufe (g).

14. Verfahren gemäß Anspruch 13, worin die bildweise belichtete, dielektrische Folie auf einem porösen Träger entwickelt und getrocknet wird.

15. Verfahren zur Herstellung einer Mehrschichten-Ergebnis-Verbindungsschaltung unter Verwendung einer lichtempfindlichen, selbsttragenden, dielektrischen Folie gemäß Anpruch 7, umfassend die aufeinanderfolgenden Stufen:
(a) der bildweisen Belichtung beider Seiten der selbsttragenden, lichtempfindlichen, dielektrischen Folie mit aktinischer Strahlung durch ein paßgenaues und ausgerichtetes Paar von Bildern eines Kontaktlochmusters und gegebenenfalls eines Hohlraummusters;
(b) der Entwicklung der belichteten Folie in einer verdünnten, wäßrigen, sauren oder basischen Lösung, die 0,8 bis 2,0 Gew.-% Säure oder Base enthält, um eine gemusterte Anordnung von Durchgangslöchern und gegebenenfalls Hohlräumen zu bilden;
(c) des Trocknens der entwickelten Folie;
(d) des Metallisierens der Durchgangslöcher mit einer leitfähigen Zusammensetzung;
(e) des wahlweisen Auftragens einer gemusterten, elektrisch-funktionellen Schicht auf die dielektrische Folie in paßgenauer Übereinstimmung mit dem Durchgangsmuster und allen Hohlräumen in der Folie;
(f) des Wiederholens der Stufen (a) bis (e) mit dem erwünschten Durchgangsloch, dem Hohlraum und den elektrisch-funktionellen Mustern, bis die erwünschte Anzahl von Schichten gebildet worden ist;
(g) des Laminierens der Schichten der Stufe (f), um eine Anordnung von untereinander verbundenen, elektrisch-funktionellen Schichten zu bilden, die durch das dielektrische Material getrennt sind; und
(h) des gemeinsamen Brennens der Anordnung der Stufe (g).

16. Verfahren gemäß Anspruch 15, worin:
eine Seite wenigstens einer der lichtempfindlichen, dielektrischen Folien in der Stufe (a) durch ein Bild bildweise belichtet wird, umfassend ein Durchgangsloch und gegebenenfalls ein Hohlraummuster und ein Muster für ein anderes elektrisch-funktionelles Merkmal, wobei die gegenüberliegende Seite der Folie durch ein paßgenaues und ausgerichtetes Bild des Durchgangsloch- und gegebenenfalls des Hohlraummusters belichtet wird;
in der Stufe (b) die Folie entwickelt wird, um eine gemusterte Anordnung von Durchgangslöchern und gegebenenfalls Hohlräumen durch die Folie und eine gemusterte Vertiefung in Form eines elektrisch-funktionellen Merkmals in einer Seite der Folie zu bilden; und
die gemusterte Vertiefung mit einer leitfähigen Zusammensetzung oder einer Widerstandszusammensetzung metallisiert wird.

17. Verfahren gemäß Anspruch 16, worin:
in der Stufe (a) die gegenüberliegende Seite wenigstens einer lichtempfindlichen, dielektrischen Folie durch ein paßgenaues und ausgerichtetes Bild belichtet wird, welches das gleiche Durchgangsloch- und Hohlraummuster umfaßt und weiterhin ein Muster für ein anderes elektrisches Merkmal umfaßt; und
bei der Entwicklung in der Stufe (b) der Folie eine gemusterte Anordnung von Durchgangslöchern und gegebenenfalls Hohlräumen durch die Folie gebildet wird und eine gemusterte Vertiefung in Form eines elektrischen Merkmals in jeder Seite der Folie gebildet wird.

18. Verfahren gemäß den Ansprüchen 15, 16 oder 17, worin die bildweise belichtete, dielektrische Folie auf einem porösen Träger entwickelt und getrocknet wird.

19. Verfahren gemäß den Ansprüchen 15, 16 oder 17, worin jede Seite der dielektrischen Folie der Reihe nach in der Stufe (b) durch das geeignete Bild einer paßgenauen und ausgericheten Reihe von Bildern bildweise belichtet wird.

20. Verfahren gemäß den Ansprüchen 15, 16 oder 17, worin beide Seiten der dielektrischen Folie in der Stufe (b) durch ein paßgenaues und ausgerichetes Paar von Bildern gleichzeitig bildweise belichtet werden.

21. Verfahren gemäß irgendeinem der Ansprüche 13 bis 20, weiterhin umfassend:
(i) das Auftragen einer gemusterten, elektrisch-funktionellen Schicht in paßgenauer Übereinstimmung mit dem Durchgangsmuster und aller darin vorliegenden Hohlräumen auf eine oder beide der äußersten Flächen der gebrannten Anordnung;
(j) das Brennen der Struktur aus der Stufe (i);
(k) das Wiederholen der Stufen (i) und (j) so oft es notwendig ist, um das (die) gewünschte(n) äußere(n) Schaltungsmuster zu bilden.

## Revendications

1. Composition de feuille diélectrique coulable, photosensible, autoporteuse, ladite composition comprenant :
un mélange :
a) de particules finement divisées d'un liant inorganique, et
b) facultativement, de particules finement divisées de solides céramiques;
dispersées dans un milieu organique contenant :
c) un liant polymère organique comprenant un polymère organique contenant des amines ou un copolymère, un interpolymère ou mélanges de ceux-ci, chaque copolymère ou interpolymère comprenant (1) un comonomère non acide d'acrylate d'alkyle en C₁-C₁₀, de méthacrylate d'alkyle en C₁-C₁₀, de styrène, de styrène substitué ou d'une combinaison de ceux-ci, et (2) un comonomère acide comprenant une partie contenant un acide carboxylique éthyléniquement insaturé, le copolymère ou l'interpolymère ou mélange présentant une teneur en acide d'au moins 15% en poids du poids de polymère total, et le poids moléculaire moyen en poids du liant se situant dans l'intervalle compris entre 50 000 et 500 000 ou plus, et la température de transition vitreuse moyenne du liant se situant dans l'intervalle compris entre 50°C et 100°C, et
d) un photoinitiateur dissous dans un
e) monomère photodurcissable, et
f) un solvant organique,
la composition pouvant être développée, suite à une exposition sous forme d'image à un rayonnement actinique dans une solution aqueuse diluée acide ou alcaline contenant 0,8 à 2,0% en poids d'acide ou de base.

2. Composition suivant la revendication 1, dans laquelle le poids moléculaire moyen en poids du liant polymère organique ou mélange de liants polymères se trouve dans l'intervalle compris entre 50 000 et 400 000.

3. Composition suivant la revendication 2, dans laquelle le poids moléculaire moyen en poids du liant polymère organique ou mélange de liants polymères se trouve dans l'intervalle compris entre 50 000 et 250 000.

4. Composition suivant la revendication 1, dans laquelle le liant polymère organique est un copolymère ou interpolymère ou des mélanges de ceux-ci, chaque copolymère ou interpolymère comprenant (1) un comonomère non acide d'acrylate d'alkyle en C₁-C₁₀, de méthacrylate d'alkyle en C₁-C₁₀, de styrène, de styrène substitué ou d'une combinaison de ceux-ci, et (2) un comonomère acide comprenant une partie contenant un acide carboxylique éthyléniquement insaturé, le copolymère, l'interpolymère ou mélange présentant une teneur en acide d'au moins 15% en poids du poids de polymère total.

5. Composition suivant la revendication 4, dans laquelle les parties de liant polymère organique dérivées de l'acide carboxylique insaturé ne présentent pas plus de 30% en poids du liant.

6. Composition suivant la revendication 5, dans laquelle le liant polymère organique est un terpolymère de méthacrylate de méthyle, d'acrylate d'éthyle et d'acide méthacrylique.

7. Feuille diélectrique verte photosensible autoporteuse, comprenant :
un mélange :
a) de particules finement divisées d'un liant inorganique, et
b) facultativement, de particules finement divisées de solides céramiques;
dispersées dans un milieu organique contenant :
c) un liant polymère organique comprenant un polymère organique contenant des amines, ou un copolymère, un interpolymère ou mélanges de ceux-ci, chaque copolymère ou interpolymère comprenant (1) un comonomère non acide d'acrylate d'alkyle en C₁-C₁₀, de méthacrylate d'alkyle en C₁-C₁₀, de styrène, de styrène substitué ou d'une combinaison de ceux-ci, et (2) un comonomère acide comprenant une partie contenant un acide carboxylique éthyléniquement insaturé, le copolymère ou l'interpolymère ou mélange présentant une teneur en acide d'au moins 15% en poids du poids de polymère total, et le poids moléculaire moyen en poids du liant se situant dans l'intervalle compris entre 50 000 et 500 000 ou plus et la température de transition vitreuse moyenne du liant se situant dans l'intervalle compris entre 50°C et 100°C, et
d) un photoinitiateur dissous dans un
e) monomère photodurcissable,
la composition pouvant être développée, suite à une exposition sous forme d'image à un rayonnement actinique dans une solution aqueuse diluée acide ou alcaline contenant 0,8 à 2,0% en poids d'acide ou de base.

8. Feuille diélectrique suivant la revendication 7, dans laquelle le poids moléculaire moyen en poids du liant polymère organique ou mélange de liants polymères se situe dans l'intervalle compris entre 50 000 et 400 000.

9. Feuille diélectrique suivant la revendication 8, dans laquelle le poids moléculaire moyen en poids du liant polymère organique ou mélange de liants polymères se situe dans l'intervalle compris entre 50 000 et 250 000.

10. Feuille diélectrique suivant la revendication 7, dans laquelle le liant polymère organique contient un copolymère ou interpolymère ou des mélanges de ceux-ci, chaque copolymère ou interpolymère comprenant (1) un comonomère non acide d'acrylate d'alkyle en C₁-C₁₀, de méthacrylate d'alkyle en C₁-C₁₀, de styrène, de styrène substitué ou d'une combinaison de ceux-ci, et (2) un comonomère acide comprenant une partie contenant un acide carboxylique éthyléniquement insaturé, le copolymère, l'interpolymère ou mélange présentant une teneur en acide d'au moins 15% en poids du poids de polymère total.

11. Feuille diélectrique suivant la revendication 10, dans laquelle les parties de liant polymère organique dérivées de l'acide carboxylique insaturé ne présentent pas plus de 30% en poids du liant.

12. Feuille diélectrique suivant la revendication 11, dans laquelle le liant polymère organique est un terpolymère de méthacrylate de méthyle, d'acrylate d'éthyle et d'acide méthacrylique.

13. Procédé de fabrication d'une interconnexion multicouche utilisant une feuille diélectrique photosensible autoporteuse suivant la revendication 7, comprenant les étapes séquentielles consistant à :
(a) exposer sous forme d'image la feuille diélectrique à un rayonnement actinique à travers une image d'un motif de traversées et, facultativement, un motif de creux;
(b) développer la feuille exposée dans une solution aqueuse diluée acide ou alcaline contenant 0,8 à 2,0% en poids d'acide ou de base pour former un groupement à motif de traversées et, facultativement, de creux;
(c) sécher la feuille développée;
(d) métalliser les traversées avec une composition conductrice;
(e) facultativement, appliquer sur la feuille diélectrique une couche électriquement fonctionnelle mise en motif en correspondance avec le motif de traversées et tout creux dans la feuille;
(f) répéter les étapes (a) à (e) avec le motif de traversées, de creux et électriquement fonctionnel souhaité jusqu'à ce que le nombre souhaité de couches ait été formé;
(g) laminer les couches de l'étape (f) pour former un assemblage de couches interconnectées électriquement fonctionnelles séparées par un matériau diélectrique, et
(h) cuire la totalité de l'assemblage de l'étape (g).

14. Procédé suivant la revendication 13, dans lequel la feuille diélectrique exposée sous forme d'image est développée et séchée sur un support poreux.

15. Procédé de fabrication d'un circuit d'interconnexion multicouche utilisant une feuille diélectrique photosensible autoporteuse suivant la revendication 7, comprenant les étapes séquentielles consistant à :
(a) exposer sous forme d'image les deux faces de la feuille diélectrique photosensible autoporteuse à un rayonnement actinique à travers une paire d'images mises en correspondance et alignées d'un motif de traversées et, facultativement, d'un motif de creux;
(b) développer la feuille exposée dans une solution aqueuse diluée acide ou alcaline contenant 0,8 à 2,0% en poids d'acide ou de base pour former un groupement à motif de traversées et, facultativement, de creux;
(c) sécher la feuille développée;
(d) métalliser les traversées avec une composition conductrice;
(e) facultativement appliquer sur la feuille diélectrique une couche électriquement fonctionnelle à motif en correspondance avec le motif de traversées et tout creux dans la feuille;
(f) répéter les étapes (a) à (e) avec les motifs de traversées, de creux et électriquement fonctionnels souhaités jusqu'à ce que le nombre souhaité de couches ait été formé;
(g) laminer les couches de l'étape (f) pour former un assemblage de couches interconnectées électriquement fonctionnelles séparées par un matériau diélectrique, et
(h) cuire la totalité de l'assemblage de l'étape (g).

16. Procédé suivant la revendication 15, dans lequel
une face d'au moins une des feuilles diélectriques photosensibles est exposée sous forme d'image au cours de l'étape (a) à travers une image comprenant un motif de traversées et, facultativement, de creux, et un motif pour une autre particularité électriquement fonctionnelle, la face opposée de la feuille étant exposée à travers une image mise en correspondance et alignée dudit motif de traversées et de creux facultatifs;
au cours de l'étape (b), ladite feuille est développée pour former un groupement à motif de traversées et, facultativement, de creux à travers la feuille et un retrait à motif sous la forme d'une particularité électriquement fonctionnelle dans une face de la feuille, et
le retrait à motif est métallisé avec une composition conductrice ou résistive.

17. Procédé suivant la revendication 16, dans lequel
au cours de l'étape (a), la face opposée d'au moins une feuille diélectrique photosensible est exposée à travers une image mise en correspondance et alignée comprenant le même motif de traversées et de creux, et comprenant en outre un motif pour une autre particularité électrique, et
suite au développement de ladite feuille au cours de l'étape (b), on forme un groupement à motif de traversées et, facultativement, de creux à travers la feuille et un retrait à motif sous la formé d'une particularité électrique dans chaque face de la feuille.

18. Procédé suivant la revendication 15, 16 ou 17, dans lequel la feuille diélectrique exposée sous forme d'image est développée et séchée sur un support poreux.

19. Procédé suivant la revendication 15, 16 ou 17, dans lequel chaque face de la feuille diélectrique est exposée sous forme d'image chacun à son tour au cours de l'étape (b) à travers l'image appropriée d'un jeu d'images mises en correspondance et alignées.

20. Procédé suivant la revendication 15, 16 ou 17, dans lequel les deux faces de la feuille diélectrique sont exposées sous forme d'image simultanément au cours de l'étape (b) à travers une paire d'images mises en correspondance et alignées.

21. Procédé suivant l'une quelconque des revendications 13 à 20, comprenant en outre les étapes consistant à :
(i) appliquer, sur l'une ou les deux surfaces les plus à l'extérieur de l'assemblage cuit, une couche à motif électriquement fonctionnelle en correspondance avec le motif de traversées et tout creux dans celle-ci;
(j) cuire la structure de l'étape (i), et
(k) répéter les étapes (i) et (j) autant de fois que nécessaire pour former le ou les motif(s) de circuit de couche externe souhaité(s).
